# EUROPEAN PATENT SPECIFICATION

(11) **EP 4 350 363 B1**
(45) Date of publication and mention of the grant of the patent: **28.10.2026**
(21) Application number: 22757609.7
(22) Date of filing: 15.06.2022
(51) Int. Cl.: G01R 19/00

(54) **SMART VOLTAGE DISCRIMINATOR FOR A MULTI-VOLTAGE SOURCE**
INTELLIGENTER SPANNUNGSDISKRIMINATOR FÜR EINE MEHRSPANNUNGSQUELLE
DISCRIMINATEUR DE TENSION INTELLIGENT POUR SOURCE MULTI-TENSION

(43) Date of publication of application: 10.04.2024
(73) Proprietor: Chaves García, Jordi, 08450 Llinars del Vallès (Barcelona) (ES); Chaves García, Juan Miguel, 08450 Llinars del Vallès (Barcelona) (ES)
(72) Inventor: Chaves García, Jordi, 08450 Llinars del Vallès (Barcelona) (ES); Chaves García, Juan Miguel, 08450 Llinars del Vallès (Barcelona) (ES)
(74) Representative: Hernández Hernández, Carlos
(86) International application number: PCT/ES2022/070376
(87) International publication number: WO 2023/203261

(56) References cited:
- US-A- 4 728 898
- US-A1- 2010 315 102
- US-A1- 2011 234 203
- US-A1- 2017 336 464

## Description

### OBJECT OF THE INVENTION

The object of the present invention relates to a smart voltage discriminator for a multi-voltage source having the particularity that it adapts to the input voltage.

The present invention is characterized by the special design and configuration of each and every one of the elements used in such a way as to achieve a discriminator that is highly functional, simple and energy-saving.

Therefore, the present invention is comprised within the field of devices used in voltage discrimination.

### BACKGROUND OF THE INVENTION

In the state of the art, when several cables run in parallel, especially in long distances of several hundred meters, the fact is that in some of the cables, although they do not have any voltage, a voltage is induced by coupling and/or by a lack of quality of the cables, this gives rise to false signals that are a source of erroneous maneuvers, so it is necessary to be able to discriminate which of the voltages that run through the cables is the good signal.

In the state of the art, this signal discrimination is done by means of an optocoupler and a resistor. Although it is a possible way to achieve signal discrimination, this embodiment presents significant energy consumption problems, since energy is continuously being dissipated, and there are even situations wherein it is not possible to discriminate the correct input.

In addition, the discriminator must be suitable for high voltage range multi-voltage sources, which could range from 24 V to 240 Volts. Therefore, the discriminator must be designed in such a way that it adapts to the input voltage.

US 4 728 898 A1 discloses a low-cost transmission line fault detector visually indicates the nature and location of transmission line failures. US 2017/336464 A1 discloses a method for generating an error signal indicating an error type of an error in a multi-phase electrical energy supply network. US2010/315102A1, which discloses a device for quantifying an electric unbalance and touch detection system incorporating it.

Discriminators that adapt to the input voltage are unknown in the state of the art.

Therefore, an object of the present invention relates to developing a voltage discriminator suitable for multi-voltage sources, wherein the discriminator itself adapts automatically to the input voltage, wherein the discriminator furthermore has a lower energy consumption, is of great simplicity and high functionality, developing a discriminator like the one described below and the essential nature of which is described in claim 1.

### DISCLOSURE OF THE INVENTION

The essential nature of the object of the present invention is described in the independent claim 1.

The object of the present invention relates to a smart voltage discriminator for a multi-voltage source comprising a series of inputs, preferably three, wherein one of them is for a common signal and the other two are the signals to be discriminated, with each of the three signals being input to a three-phase rectifier bridge, wherein a measurement signal is taken from the signals to be discriminated by means of a high impedance measurement resistor, allowing a very low current to pass, with each high impedance resistor being connected in series with an offset signal generator and the output of which is compared with the other signal without any reduction in value in a comparator, wherein the output of each comparator is a logic value "1" or "0" if the value is greater than a threshold value or not, respectively.

Each of the generators of the offset signal of each signal to be discriminated comprises a voltage source generating an offset value of the voltage, with the output thereof being connected with a resistor and the entire voltage source and resistor assembly is connected in parallel with a capacitor, and a reduced signal of the signal to be analyzed is taken from the connection point between the voltage source and the resistor and taken to a comparator.

Said capacitor has the function of filtering and getting the comparison to be made with an approximation of the mean size of the input signal, and not of the peak voltage. The mean voltage provided by the capacitor is more reliable than a peak voltage.

The discriminator comprises two comparators, a first comparator and a second comparator, wherein in the first comparator the first signal without any offset is compared with the second signal to which an offset has been applied, whereas in the second comparator the second signal without any offset is compared with the first signal to which an offset has been applied.

The output of each comparator is a logic signal of "1" or "0" according to whether the difference of the comparator is greater than a preestablished threshold value in such a way that the output of the comparator that provides a value of "0" is discarded.

Unless indicated otherwise, all the technical and scientific elements used in the present specification have the meaning that is usually understood by one skilled in the art to which this invention belongs. When putting the present invention into practice, methods and materials similar or equivalent to those described in the specification can be used.

Throughout the description and the claims, the word "comprises", and variants thereof are not intended to exclude other technical features, additives, components or steps. For those skilled in the art, other objects, advantages and features of the invention will be inferred in part from the description and in part from practice of the invention.

### BRIEF DESCRIPTION OF THE FIGURES

To complement the description being made and for the purpose of helping to better understand the features of the invention according to a preferred practical embodiment thereof, a set of drawings is attached as an integral part of said description, in which drawings the following has been depicted in an illustrative and non-limiting manner.

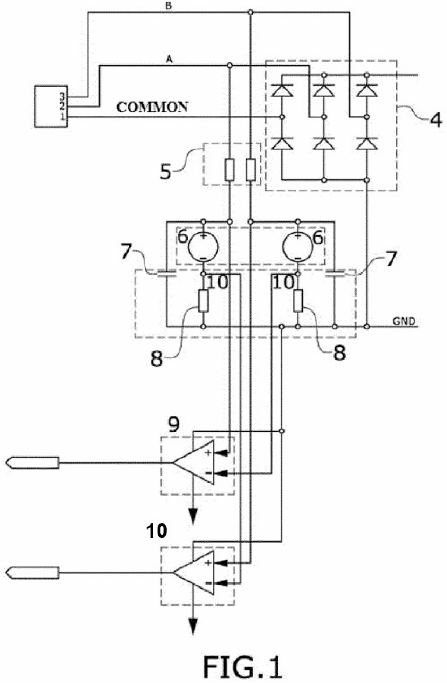

Figure 1 shows a depiction of the electrical diagram of the discriminator object of the invention.

### PREFERRED EMBODIMENT OF THE INVENTION

In Figure 1, it can be observed that the discriminator object of the invention comprises a series of inputs (1), (2) and (3) which correspond with a signal (COMMON), signal (A) and signal (B) respectively, wherein the intention is to be able to discriminate whether one of the signals is an incorrect signal despite having a certain voltage.

The voltage in one of the cables can be the result of excessive noise, excessive length or a combination of factors, with it being necessary to be able to discriminate whether the voltage shown in one of the cables is a valid voltage or not.

This has an important relevance, especially for valve command signals and the like.

The signals (COMMON), (A) and (B) are taken to a rectifier bridge (4), where a feed signal is obtained.

Signals (A) and (B) are the signals to be discriminated and before the input to the bridge rectifier a connecting cable is derived on which a high impedance measuring resistor (5) is arranged followed by an offset signal generator, the output of which is in connection with a comparator.

Each of the offset signal generators, both for signal (A) and for signal (B), comprises a voltage source (6) generating an offset value of the voltage with the output thereof being connected with a resistor (8), and the entire voltage source (6) and resistor (8) assembly is connected in parallel with a capacitor (7), and a reduced signal (10) of the signal to be analyzed is taken from the connection point between the voltage source (6) and the resistor (8) and taken to a comparator (9), (10).

The discriminator comprises a first comparator (9) and a second comparator (10), wherein signal (A) without any offset and signal (B) to which an offset has been applied reach the first comparator (9) in order to be compared, whereas signal (B) without any offset and signal (A) to which an offset has been applied reach the second comparator in order to be compared.

The discriminator truth table is:

| | A > B + 8V | B > A + 8V | Other result |
|---|---|---|---|
| Comparator (9) | 1 | 0 | 1 |
| Comparator (10) | 0 | 1 | 1 |

Therefore, as can be observed, when signal (A) is greater than signal (B) to which an offset of 8 volts has been applied, for example, a "1" is generated in the comparator (9), whereas when signal (B) is greater than a signal (A) offset by said 8 volts, a "0" is generated, or a "1" being generated in other cases, whereas in the comparator (10) when voltage (A) is greater than signal (B) offset by more than 8 volts, for example, a value of "0" is generated, whereas when signal (B) is greater than a signal (A) offset by those 8 volts, a "1" is generated, or a "1" being generated in other cases.

It can also be observed in the table that the discriminator is capable of identifying two signals as valid, when they are separated by less than 8V.

This allows those signals resulting from induction due to noise or excessive length in parallel with other cables to be discriminated, wherein discrimination is carried out in a simple and highly effective manner with energy savings.

## Claims

1. A smart voltage discriminator for discriminating the signal lines of a multi-voltage source, which range from 24 V to 240 Volts wherein the smart voltage discriminator comprises:
- three inputs consisting of a first input (1), a second input (2) and a third input (3), wherein the first input (2) is configured to receive a first signal (A), the second input (3) is configured to receive a second signal (B) and the third input (1) is configured to receive a common signal (COMMON) wherein the first signal (A) and the second signal (B)are signals to be discriminated;
- a three -phase rectifier bridge (4) connected to the first input (2), the second input (3), and the third input (1) wherein the connection is respectively established via a first connecting line , a second connecting line , and a third connecting line , wherein a first measurement signal is taken from the first connecting line and a second measurement signal is taken from the second connecting line , and wherein the first measurement signal corresponds to the first signal (A) and the second measurement signal corresponds to the second signal (B).
- a high impedance resistor (5) consisting of a first high impedance resistor and a second high impedance resistor, wherein each one of the first high impedance resistor and the second high impedance resistor comprises a first terminal and a second terminal , wherein the first terminal of the first impedance resistor is connected to the first connecting line and wherein the first terminal of the second impedance resistor is connected to the second connecting line;
- An offset signal generator consisting of a first offset signal generator and a second offset signal generator , wherein the offset value voltage generated is around 8 volts , wherein each one of the first offset signal generator and the second offset signal generator comprises respectively a first terminal, a second terminal, a third terminal, a voltage source (6) generating the offset value voltage and connected between the first terminal and the second terminal in such a way that a reduced signal of the signal at the first terminal is generated at the second terminal, a resistor (8) connected between the second terminal and the third terminal , and a capacitor (7) connected between the first terminal and the third terminal , wherein the first terminal of the first offset signal generator is connected to the second terminal of the first high impedance resistor , wherein the third terminal of the first offset signal generator is connected to ground (GND ), wherein the first terminal of the second offset signal generator is connected to the second terminal of the second high impedance resistor, and wherein the third terminal of the second offset signal generator is connected to ground (GND ) ; and
- a first comparator (9) and a second comparator (10) wherein each one of the first comparator and the second comparator comprises a first input terminal, a second input terminal and an output terminal , wherein each respective output signal of the first comparator and the second comparator is a logic value " 1 " or "0" if the value is greater than a threshold value or not, respectively ,
the smart voltage discriminator being **characterised in that**:
the first input terminal of the first comparator is connected to the first terminal of the first offset signal generator and the second input terminal of the first comparator is connected to the second terminal of the second offset signal generator, such that the first signal (A) without any offset is compared with the second signal (B) to which an offset has been applied; and
the first input terminal of the second comparator is connected to the first terminal of the second offset signal generator and the second input terminal of the second comparator is connected to the second terminal of the first offset signal generator, such that the second signal (B) without any offset is compared with the first signal (A) to which an offset has been applied.

## Patentansprüche

1. Intelligenter Spannungsdiskriminator zum Unterscheiden der Signalleitungen einer Mehrfachspannungsquelle, die im Bereich von 24 V bis 240 V liegen, wobei der intelligente Spannungsdiskriminator Folgendes umfasst:
- drei Eingänge, bestehend aus einem ersten Eingang (1), einem zweiten Eingang (2) und einem dritten Eingang (3), wobei der erste Eingang (2) dazu konfiguriert ist, ein erstes Signal (A) zu empfangen, der zweite Eingang (3) dazu konfiguriert ist, ein zweites Signal (B) zu empfangen, und der dritte Eingang (1) dazu konfiguriert ist, ein gemeinsames Signal (COMMON) zu empfangen, wobei das erste Signal (A) und das zweite Signal (B) zu unterscheidende Signale sind;
- eine dreiphasige Gleichrichterbrücke (4), die mit dem ersten Eingang (2), dem zweiten Eingang (3) und dem dritten Eingang (1) verbunden ist, wobei die Verbindung jeweils über eine erste Verbindungsleitung, eine zweite Verbindungsleitung und eine dritte Verbindungsleitung hergestellt wird, wobei von der ersten Verbindungsleitung ein erstes Messsignal und von der zweiten Verbindungsleitung ein zweites Messsignal abgegriffen wird, und wobei das erste Messsignal dem ersten Signal (A) und das zweite Messsignal dem zweiten Signal (B) entspricht;
- einen hochohmigen Widerstand (5), der aus einem ersten hochohmigen Widerstand und einem zweiten hochohmigen Widerstand besteht, wobei jeder des ersten hochohmigen Widerstands und des zweiten hochohmigen Widerstands einen ersten Anschluss und einen zweiten Anschluss umfasst, wobei der erste Anschluss des ersten impedanten Widerstands mit der ersten Verbindungsleitung verbunden ist und wobei der erste Anschluss des zweiten impedanten Widerstands mit der zweiten Verbindungsleitung verbunden ist;
- einen Offset-Signalgenerator, der aus einem ersten Offset-Signalgenerator und einem zweiten Offset-Signalgenerator besteht, wobei die erzeugte Offset-Wert-Spannung etwa 8 Volt beträgt, wobei jeder des ersten Offset-Signalgenerators und des zweiten Offset-Signalgenerators jeweils Folgendes umfasst: einen ersten Anschluss, einen zweiten Anschluss, einen dritten Anschluss, eine Spannungsquelle (6), die die Offset-Wert-Spannung erzeugt und so zwischen dem ersten Anschluss und dem zweiten Anschluss verbunden ist, dass ein reduziertes Signal des Signals am ersten Anschluss am zweiten Anschluss erzeugt wird, einen Widerstand (8), der zwischen dem zweiten Anschluss und dem dritten Anschluss verbunden ist, und einen Kondensator (7), der zwischen dem ersten Anschluss und dem dritten Anschluss verbunden ist,
wobei der erste Anschluss des ersten Offset-Signalgenerators mit dem zweiten Anschluss des ersten hochohmigen Widerstands verbunden ist, wobei der dritte Anschluss des ersten Offset-Signalgenerators mit Masse (GND) verbunden ist, wobei der erste Anschluss des zweiten Offset-Signalgenerators mit dem zweiten Anschluss des zweiten hochohmigen Widerstands verbunden ist, und wobei der dritte Anschluss des zweiten Offset-Signalgenerators mit Masse (GND) verbunden ist; und
- einen ersten Komparator (9) und einen zweiten Komparator (10), wobei jeder des ersten Komparators und des zweiten Komparators einen ersten Eingangsanschluss, einen zweiten Eingangsanschluss und einen Ausgangsanschluss umfasst, wobei jedes jeweilige Ausgangssignal des ersten Komparators und des zweiten Komparators ein logischer Wert "1" oder "0" ist, je nachdem, ob der Wert jeweils größer als ein Schwellenwert ist oder nicht,
wobei der intelligente Spannungsdiskriminator **dadurch gekennzeichnet ist, dass**:
der erste Eingangsanschluss des ersten Komparators mit dem ersten Anschluss des ersten Offset-Signalgenerators verbunden ist und der zweite Eingangsanschluss des ersten Komparators mit dem zweiten Anschluss des zweiten Offset-Signalgenerators verbunden ist, sodass das erste Signal (A) ohne jeglichen Offset mit dem zweiten Signal (B), auf das ein Offset angewendet wurde, verglichen wird; und
der erste Eingangsanschluss des zweiten Komparators mit dem ersten Anschluss des zweiten Offset-Signalgenerators verbunden ist und der zweite Eingangsanschluss des zweiten Komparators mit dem zweiten Anschluss des ersten Offset-Signalgenerators verbunden ist, sodass das zweite Signal (B) ohne jeglichen Offset mit dem ersten Signal (A), auf das ein Offset angewendet wurde, verglichen wird.

## Revendications

1. Un discriminateur de tension intelligent destiné à distinguer les lignes de signal d'une source à tensions multiples, dont les tensions varient de 24 V à 240 V, ledit discriminateur de tension intelligent comprenant :
- trois entrées comprenant une première entrée (1), une deuxième entrée (2) et une troisième entrée (3), où la première entrée (2) est configurée pour recevoir un premier signal (A), la deuxième entrée (3) est configurée pour recevoir un deuxième signal (B) et la troisième entrée (1) est configurée pour recevoir un signal commun (COMMON), et où le premier signal (A) et le deuxième signal (B) sont des signaux à distinguer ;
- un pont redresseur triphasé (4) relié à la première entrée (2), à la deuxième entrée (3), et à la troisième entrée (1), où la connexion est établie respectivement via une première ligne de connexion, une deuxième ligne de connexion et une troisième ligne de connexion, où un premier signal de mesure est prélevé sur la première ligne de connexion et un deuxième signal de mesure est prélevé sur la deuxième ligne de connexion, et où le premier signal de mesure correspond au premier signal (A) et le deuxième signal de mesure correspond au deuxième signal (B).
- une résistance à haute impédance (5) composée d'une première résistance à haute impédance et d'une deuxième résistance à haute impédance, où chacune de ces résistances comprend une première borne et une deuxième borne, où la première borne de la première résistance à haute impédance est reliée à la première ligne de connexion et où la première borne de la deuxième résistance à haute impédance est reliée à la deuxième ligne de connexion ;
- un générateur de signal de décalage composé d'un premier générateur de signal de décalage et d'un deuxième générateur de signal de décalage, où la tension de décalage générée est d'environ 8 volts, où le premier générateur de signal de décalage et le deuxième générateur de signal de décalage comprennent respectivement une première borne, une deuxième borne, une troisième borne, une source de tension (6) générant la tension de décalage et connectée entre la première borne et la deuxième borne de telle sorte qu'un signal atténué du signal présent au niveau de la première borne soit généré au niveau de la deuxième borne, une résistance (8) connectée entre la deuxième borne et la troisième borne, et un condensateur (7) connecté entre la première borne et la troisième borne, où la première borne du premier
générateur de signal de décalage est connecté à la deuxième borne de la première résistance à haute impédance, la troisième borne du premier générateur de signal de décalage étant connectée à la masse (GND), la première borne du deuxième générateur de signal de décalage étant connectée à la deuxième borne de la deuxième résistance à haute impédance, et la troisième borne du deuxième générateur de signal de décalage étant connectée à la masse (GND) ; et
- un premier comparateur (9) et un deuxième comparateur (10), chacun d'entre eux comprenant une première borne d'entrée, une deuxième borne d'entrée et une borne de sortie, où chaque signal de sortie respectif du premier comparateur et du deuxième comparateur prend la valeur logique « 1 » ou « 0 » selon que la valeur est supérieure ou non à une valeur seuil, respectivement,
le discriminateur de tension intelligent **se caractérisant par le fait que** :
la première borne d'entrée du premier comparateur est reliée à la première borne du premier générateur de signal de décalage et la deuxième borne d'entrée du premier comparateur est reliée à la deuxième borne du deuxième générateur de signal de décalage, de sorte que le premier signal (A), dépourvu de tout décalage, soit comparé au deuxième signal (B) auquel un décalage a été appliqué ; et
la première borne d'entrée du deuxième comparateur est reliée à la première borne du deuxième générateur de signal de décalage et la deuxième borne d'entrée du deuxième comparateur est reliée à la deuxième borne du premier générateur de signal de décalage, de sorte que le deuxième signal (B), dépourvu de tout décalage, soit comparé au premier signal (A) auquel un décalage a été appliqué.
